# EUROPÄISCHE PATENTSCHRIFT

(11) **EP 0 332 206 B1**
(45) Veröffentlichungstag und Bekanntmachung des Hinweises auf die Patenterteilung: **08.06.1994**
(21) Anmeldenummer: 89104271.5
(22) Anmeldetag: 10.03.1989
(51) Int. Cl.: B65H 29/64

(54) **Verfahren und Vorrichtung zum Ablösen einer Abdeckfolie**
Method and apparatus for removing a protection sheet
Procédé et dispositif de séparation d'une feuille de protection

(30) Priorität: 10.03.1988 DE 3807952
(43) Veröffentlichungstag der Anmeldung: 13.09.1989
(73) Patentinhaber: Gebr. Schmid GmbH & Co., D-72250 Freudenstadt (DE)
(72) Erfinder: Dippon, Siegfried, Dipl.-Ing., D-7268 Gechingen (DE)
(74) Vertreter: Patentanwälte Ruff, Beier, Schöndorf und Mütschele

(56) Entgegenhaltungen:
- EP-A- 0 218 873
- US-A- 4 324 705
- PATENT ABSTRACTS OF JAPAN vol. 11, no. 247 (M-615)(2694) 12 August 1987,& JP-A-62 56246 (SOMAR CORP.) 11 März 1987,

## Beschreibung

Die Erfindung betrifft ein Verfahren zum Ablösen einer Abdeckfolie von einem plattenförmigen Träger, insbesondere zum Ablösen eines eine Fotolackschicht auf einer Leiterplatte abdeckenden Schutzfilms, wobei in einem ersten Schritt eine Kante der Abdeckfolie durch eine Ablösevorrichtung abgehoben und in einem zweiten Schritt durch eine Folientransportvorrichtung erfaßt wird, die die Folie bei fortschreitender Ablösung von dem Träger aus dem Bereich der Ablösevorrichtung entfernt.

Die Erfindung betrifft weiterhin eine Vorrichtung zum Ablösen einer Abdeckfolie von einem plattenförmigen Träger, insbesondere zum Ablösen eines eine Fotolackschicht auf einer Leiterplatte abdeckenden Schutzfilms, wobei die Vorrichtung eine Fördervorrichtung für die plattenförmigen Träger, eine eine oder mehrere Flüssigkeitsdüsen enthaltende Ablösevorrichtung und eine Folientransportvorrichtung umfaßt, wobei die Flüssigkeitsdüsen benachbart zu der durch die Fördervorrichtung gebildete Transportebene angeordnet sind.

Aus der EP-A-218 873 sind ein Verfahren und eine Vorrichtung zum Abziehen einer Abdeckfolie bekanntgeworden, bei der die vordere Kante der Schutzfolie durch eine rotierende Bürste mit Stahl- oder harten Kunststoffnadeln angehoben wird. Danach wird durch Flüssigkeits- oder Gasstrahlen, die in die nach der Kantenanhebung keilförmige Lücke eindringen, die Schutzfolie beim Durchlauf allmählich abgehoben.

Die US-A-4 324 705 beschreibt ein Verfahren zur Wiedergewinnung einer Schicht, beispielsweise der Fotoemulsion, durch chemisch/physikalisches Anlösen und anschließendes Abheben und Entfernen der angelösten Fotoemulsion mit Hochdruckflüssigkeitsstrahlen.

Ein solches Verfahren und eine solche Vorrichtung sind beispielsweise aus der EP-A 232 841 bekannt. Gemäß diesem bekannten Verfahren wird die vordere Kante der Abdeckfolie dadurch abgehoben, daß beispielsweise ein Rändelrad über die gesamte Breite der in die Vorrichtung eingeführten Leiterplatte geführt und dabei auf den Abdeckfilm gepreßt wird, so daß die in Transportrichtung vorstehende Kante des Abdeckfilms sich durch den Druck des Rändelrads ablöst und nach oben absteht. Im Anschluß daran wird durch Düsen ein Fluid in den zwischen Folie und Trägerplatte entstandenen Zwischenraum geblasen oder gesprüht, um ein weiteres Ablösen der Folie zu begünstigen. Die Folie wird an der abgehobenen Kante durch eine Folientransportvorrichtung erfaßt und in einen Folienabfallbehälter gefördert.

Daneben sind weitere Verfahren zum anfänglichen Ablösen einer Abdeckfolie bekannt, die jedoch ebenfalls den Schritt des mechanischen Abhebens der vorderen Kante der Abdeckfolie von der Leiterplatte beinhalten. Da unterhalb der Abdeckfolie eine Schicht aus Fotoresistlack angeordnet ist, der bereits belichtet ist und die Information zur Herstellung der auf der Leiterplatte zu realisierenden Leiterbahnen enthält, ist eine solche mechanische Entfernung der Abdeckfolie sehr kritisch zu sehen, da dabei eine Verletzung der Fotoresistschicht auftreten kann.

Andere Methoden sind für den Fotolack wesentlich schonender, so z.B. die Methoden, die mit einer Walze einen Klebestreifen auf die Abdeckfolie aufbringen und mittels des Klebestreifens die Abdeckfolie abziehen, oder auch Vorrichtungen, bei denen eine gesonderte Abziehfolie auf die Abdeckfolie geschweißt wird und diese mit Hilfe der Abziehfolie dann von dem Trägermaterial abgezogen wird. Diese Verfahren weisen mehrere Nachteile auf, wobei insbesondere im Falle der Klebestreifenmethode stets die Schwierigkeit besteht, daß ein passender Klebestreifen gefunden werden muß, der an der Abdeckfolie eine größere Haftung in sehr kurzer Zeit erzeugt als die Abdeckfolie gegenüber dem darunter liegenden Trägerplattenmaterial besitzt. Die Fälle, bei denen bei einzelnen Leiterplatten die Abdeckfolie nicht oder nur unvollständig abgehoben wird, steigen mit steigendem zeitlichen Durchsatz von Leiterplatten durch die Ablösevorrichtung, weshalb diese Möglichkeit der Ablösung der Abdeckfolien von den Trägerplatten, die zudem sehr umständlich ist, nur einen sehr begrenzten Einsatzbereich aufweist.

Nachteilig bei dem Verfahren, bei dem eine Abziehfolie an die Abdeckfolie angeschweißt wird, ist die dabei notwendige aufwendige Steuerung, die beispielsweise sicherstellen muß, daß eine ausreichend feste Schweißnaht zwischen Abzieh- und Abdeckfolie entsteht.

Demgegenüber stellt sich die Erfindung die Aufgabe, ein Verfahren und eine Vorrichtung zur Durchführung des Verfahrens vorzuschlagen, das zum einen die Nachteile des mechanischen Abhebens der Vorderkante der Abdeckfolie vermeidet und des weiteren die Unsicherheiten, die bei den Klebestreifen- und Anschweißverfahren bestehen, beseitigt, ohne aufwendige Steuerungen zu benötigen.

Diese Aufgabe wird bei einem Verfahren der eingangs beschriebenen Art erfindungsgemäß dadurch gelöst, daß die Kante der Abdeckfolie durch einen oder mehrere Hochdruckflüssigkeitsstrahlen von dem plattenförmigen Träger abgehoben wird.

Überraschenderweise wurde gefunden, daß sich mit Hochdruckflüssigkeitsstrahlen die Kante der Abdeckfolie abheben läßt, ohne daß der darunterliegende Fotolack eine Beschädigung erleidet, und zwar mit einer Reproduzierbarkeit, die die Prozeßsicherheit der bisher bekannten Methoden weit übertrifft.

Zweckmäßigerweise wird als Flüssigkeit bei dem erfindungsgemäßen Verfahren Wasser verwendet, da die meisten Fotolacke in der während dem Ablöseprozeß zur Verfügung stehenden Zeit gegen Wasser resistent sind und zumal die nachfolgende Entwicklung der Leiterplatten in einem wäßrigen Medium vorgenommen wird.

In der Regel ist eine Ablösung der Abdeckfolie ab einem Flüssigkeitsarbeitsdruck von 20 bar zu beobachten. Vorzugsweise wird jedoch bei dem Abheben der Kante der Abdeckfolie mit einem Druck von zirka 40 bis 60 bar gearbeitet. Bei diesen Flüssigkeitsdruckverhältnissen wird ein sicheres Abheben der Kante der Folie von der darunter liegenden Trägerplatte erreicht. Die Kante der Folie biegt sich dabei leicht nach oben, so daß das nachströmende Wasser sich zwischen die Trägerplatte bzw. die Fotolackschicht der Trägerplatte und die Abdeckfolie zwängt und im weiteren Verfahren die weitere Ablösung der Abdeckfolie begünstigt.

Zweckmäßigerweise wird man die Flüssigkeit in Form von flachen Strahlen gegen die Folienkante spritzen, wobei die flachen Strahlen so orientiert sind, daß die Längsausdehnung des Strahlquerschnitts parallel zur Folienkante verläuft.

Bei einem bevorzugten Verfahren wird die Kante der Folie auf ihrer gesamten Breite ungefähr gleichzeitig durch mehrere im Abstand auf die Kante treffende Flüssigkeitsstrahlen abgehoben. Dieses Verfahren hat den Vorteil, daß die ausgerichteten Leiterplatten, so wie sie über den Einlauftisch in die Ablösevorrichtung eingefördert werden, verarbeitet werden können.

Es kann ebenfalls vorteilhaft sein, das erfindungsgemäße Verfahren so durchzuführen, daß der oder die Hochdruckflüssigkeitsstrahlen gegen die Folienkante in einem Eckbereich der Folie gerichtet werden, wobei dann die Folie in diagonaler Richtung von dem plattenförmigen Träger abgelöst wird. Ein solches Verfahren bietet sich insbesondere dann an, wenn bereits vorhandene Ablösevorrichtungen, die noch mit einem mechanischen Ablösen eines Eckbereichs der Folie arbeiten, auf die Hochdruckablösung umgestellt werden sollen. Nachteilig ist bei diesem Verfahren ganz allgemein, daß die zunächst ungefähr parallel zur Transportrichtung ausgerichtet eingeförderten Trägerplatten in ihrer Diagonalen parallel zur Transportrichtung ausgerichtet werden müssen und zur weiteren Verarbeitung dann die Position der Trägerplatten bezüglich der Transportrichtung wieder in die ursprüngliche Lage zurückgedreht werden müssen.

Bevorzugt wird das erfindungsgemäße Verfahren so ausgeführt, daß der plattenförmige Träger zum Abheben der Folienkante in den Wirkbereich der ortsfest angeordneten Flüssigkeitsstrahlen transportiert wird. Daneben ist jedoch auch vorstellbar, die Trägerplatte in eine bestimmte Position in die Ablösevorrichtung einzufördern und dann die Hochdruckdüsen gegen die Folienkante zu bewegen bis die Vorderkante der Folie vom plattenförmigen Träger abgehoben ist.

Beim Arbeiten mit den Hochdruckflüssigkeitsstrahlen wird ein relativ hoher Durchsatz der Flüssigkeit in der Vorrichtung erzielt, weshalb entsprechend dimensionierte Abflüsse an der Vorrichtung vorzusehen sind. Dieser Aufwand läßt sich dadurch minimieren, daß man den Hochdruckflüssigkeitsstrahl lediglich zum Abheben der Folienkante auf die Abdeckfolie einwirken läßt, jedoch mindestens so lange bis die Folienkante mit ihrem vorderen Ende von der Folientransportvorrichtung erfaßt wird, wobei dann im Anschluß daran das weitere Ablösen der Folie durch einen Flüssigkeitsstrahl mit lediglich niederem Druck unterstützt wird.

Hierbei ist es zumeist ausreichend, wenn der Flüssigkeitsstrahl mit einem Flüssigkeitsdruck von bis zu 5 bar erzeugt wird. Der dabei erzeugte Wasserkeil zwischen Trägerplatte und Abdeckfolie ist ausreichend, um das weitere Ablösen der Folie sicherzustellen, während diese bereits von der Folientransportvorrichtung erfaßt und abgezogen wird. In diesem Fall reicht dann die Adhäsion zwischen benetzter Folie und Transportvorrichtung für eine sichere Führung der Folie aus.

Als besonders vorteilhaft hat es sich herausgestellt, wenn die durch den Hochdruckstrahl abgehobene Folie bzw. der abgehobene Folienteil mittels einer entgegen der Transportrichtung des plattenförmigen Trägers rotierenden Bürstenwalze der Folientransportvorrichtung zugeführt wird. Zwar ist der ablösende Flüssigkeitsstrahl selbst gegen die Transportrichtung der plattenförmigen Träger gerichtet und reicht auch in manchen Fällen durchaus aus, um die Folie dem Folientranportsystem zuzuführen, ein wesentlich sichereres Arbeiten ist jedoch erst unter Einsatz der beschriebenen Bürstenwalze gewährleistet. Die Ausfallrate beim Ablösen der Abdeckfolien von den plattenförmigen Trägern kann dadurch wesentlich verringert werden. Die Bürstenwalze kann als Zuführorgan nicht nur bei der Hochdruckablösung, sondern auch bei anderen Ablöseverfahren verwendet werden, weshalb für diesen Gedanken an sich Schutz beansprucht wird.

Bevorzugt wird bei diesem Verfahren die Umfangsgeschwindigkeit der Bürstenwalze betragsmäßig größer gewählt als die Transportgeschwindigkeit der plattenförmigen Träger. Da die Abziehgeschwindigkeit der Folie von der Trägerplatte von deren Transportgeschwindigkeit abhängig ist, erfolgt durch die größere Umfangsgeschwindigkeit der Bürstenwalze eine Straffung der Folie, so daß diese im wesentlichen glatt und ohne Falten in die Folientransportvorrichtung gelangt.

Um die Folie weiterhin glatt zu halten, wird man die Transportgeschwindigkeit in der Folientransportvorrichtung ebenfalls größer wählen als die Transportgeschwindigkeit der plattenförmigen Träger, mindestens jedoch so groß wie die Umfangsgeschwindigkeit der gegebenenfalls vorhandenen Bürstenwalze. Dies stellt sicher, daß die Folie auch auf ihrem Weg durch die Folientransportvorrichtung im wesentlichen glatt und ohne Falten bleibt. Die straffe Führung der Folie ist insbesondere dann wichtig, wenn die Folien einer Aufwickelvorrichtung zugeführt werden, wie dies weiter unten beschrieben werden wird.

Es hat sich als zweckmäßig erwiesen, die Umfangsgeschwindigkeit der Bürstenwalze und/oder der Folientransportvorrichtung bis zum zweifachen der Transportgeschwindigkeit der Trägerplatten einzustellen.

Um auch parallel zur Folientransportrichtung eine Faltenbildung sicher zu vermeiden, kann man bei bevorzugten Verfahren vorsehen, daß die im Bereich der Folientransportvorrichtung befindlichen Teile der Folie durch quer zur Transportrichtung wirkende Zugkräfte beim Abtransport aus dem Bereich der Ablösevorrichtung unterworfen werden, so daß die Folie nicht nur längs der Transportrichtung, sondern auch quer dazu gestrafft wird.

Im Stand der Technik ist bekannt, die Folien in einem einfachen Behälter zu sammeln. Da die Folien jedoch sehr dünn und damit entsprechend leicht sind, wird der Abfallbehälter relativ schnell vollgefüllt sein, ohne daß er größere Mengen an Abdeckfolien aufnehmen kann. Da in der Regel auch die räumlichen Verhältnisse keine allzu große Dimensionierung des Folienabfallbehälters erlauben, stellt die Weiterentwicklung des erfindungsgemäßen Verfahrens, bei dem am Ende der Folientransportvorrichtung die Folie einer Aufwickelvorrichtung zugeführt wird, eine sehr wesentliche Verbesserung dar.

Die Folie, die, wie zuvor beschrieben, von der Folientransportvorrichtung sowohl längs als auch quer zu ihrer Transportrichtung gestrafft wird und somit völlig glatt am Ende der Folientransportvorrichtung ankommt, kann von dem Aufwickelkern der Aufwickelvorrichtung übernommen werden, wobei sich durch das Aufwickeln der Abdeckfolien auf den Wickelkern eine äußerst günstige und raumsparende Beseitigungsmöglichkeit für die Folienabfälle ergibt.

Bei einem besonders bevorzugten Verfahren wird die am Ende der Folientransportvorrichtung ankommende Folie durch eine rotierende Bürstenwalze der Aufwickelvorrichtung zugeführt. Die Bürstenwalze lenkt dabei die Folie aus der bisherigen Transportrichtung auf den Wickelkern der Aufwickelvorrichtung um, der mit derselben Umfangsgeschwindigkeit angetrieben wird wie die Folientransportvorrichtung.

Das meist an der Folie anhaftende Wasser ist häufig ausreichend, um eine Adhäsion der Folie an dem Wickelkern zu erzeugen und somit ein sicheres Aufwickeln in der Aufwickelvorrichtung zu gewährleisten.

Zweckmäßigerweise werden die Trägerplatten während dem Ablösevorgang, insbesondere dann, wenn der Hochdruckstrahl auf die Oberfläche der Trägerplatte trifft, auf der den Düsen gegenüberliegenden Seite unterstützt, so daß die Träger, die oft sehr dünn und damit flexibel sind, nicht verbogen oder gar geknickt werden, so daß sich mit diesem Verfahren auch dünnes, sehr flexibles Trägermaterial verarbeiten läßt.

Zweckmäßigerweise wird man in einem Arbeitsgang die auf der Ober- und der Unterseite des Trägers befindliche Abdeckfolie ablösen. Dabei empfiehlt es sich, die Abdeckfolie der Ober- und der Unterseite - in Transportrichtung des Trägers gesehen - nacheinander abzulösen, da man kaum die Hochdruckdüsen derart präzise anordnen kann, daß sich die vertikalen Kräftekomponenten, die über die Hochdruckstrahlen auf die Trägerplatte wirken, ausgleichen können.

Um die abgelösten Teile der Folien sicher in die Richtungen zu lenken, die für den Folienabtransport vorgesehen sind, wird bevorzugt an jeder Stelle, an der die Folie aus der Transportrichtung in eine neue Richtung umgelenkt wird, ein oder mehrere Abweiser installiert.

Zweckmäßig ist es auch, im Bereich der Folientransportvorrichtung über einen Sensor zu kontrollieren, ob pro Leiterplatte eine Folie abgelöst wurde. Es empfiehlt sich hierbei insbesondere, das Signal des Foliensensors mit dem Signal eines Sensors zu verknüpfen, der die Position des Trägers in Transportrichtung detektiert und davon ein Austaktsignal abzuleiten, das dazu verwendet werden kann, diejenigen Trägerplatten aus dem Produktionsprozeß auszutragen oder auszutakten, bei denen die Abdeckfolie nicht korrekt entfernt wurde. Im Gegensatz zu dem bekannten Stand der Technik ist ein Austakten bei dieser Ablösevorrichtung sehr leicht und ohne Probleme möglich, da dies vollautomatisch und ohne Eingriff des Bedienungspersonals erfolgen kann. Der Stapel mit den ausgetakteten Leiterplatten kann entweder erneut in den Ablöseprozeß eingeschleust werden oder aber einer Entfernung der Abdeckfolie von Hand zugeführt werden.

Neben dem erfindungsgemäßen Verfahren wird ebenfalls eine neue und erfinderische Vorrichtung zur Durchführung dieses Verfahrens vorgeschlagen, wobei die Vorrichtung mit den aus dem Stand der Technik bekannten Vorrichtungen eine Fördervorrichtung für die plattenförmigen Träger, eine eine oder mehrere Flüssigkeitsdüsen enthaltene Ablösevorrichtung und eine Folientransportvorrichtung gemein hat, wobei die Flüssigkeitsdüsen benachbart zu der durch die Fördervorrichtung gebildete Transportebene angeordnet sind.

Ausgehend von diesem Stand der Technik wird die obengenannte Aufgabe erfindungsgemäß dadurch gelöst, daß die Flüssigkeitsdüsen der Ablösevorrichtung Hochdruckflüssigkeitsdüsen sind.

Besonders bevorzugt werden hierbei Vorrichtungen, bei denen die Düsen als Flachstrahldüsen ausgebildet sind. Bei der Verwendung von Flachstrahldüsen können, insbesondere dann, wenn die gesamte Breite der Abdeckfolie insgesamt etwa gleichzeitig von dem Trägerplattenmaterial abgehoben werden soll, weniger Düsen verwendet werden.

Bevorzugt werden hierbei Flachstrahldüsen mit einem Spritzwinkel von zirka 60 bis 80°. Dies erlaubt zum einen einen relativ weiten Abstand der einzelnen Flachstrahldüsen voneinander und gewährleistet andererseits jedoch, daß die Energie des Flüssigkeitsstrahls noch ausreichend groß ist, so daß mit Sicherheit die Kante der Abdeckfolie von der Trägerplatte abgehoben wird.

Bevorzugt wird die Strahlrichtung der Düsen so eingestellt, daß diese mit der Transportebene der Trägerplatten einen Winkel von zirka 10 bis 60° bildet.

Üblicherweise wird man den Winkel der Strahlrichtung der Düsen zur Transportebene auf einen Winkel um 45 +- 10° einstellen. Hierbei herrschen die optimalen Kräfteverhältnisse für eine Ablösung der Kante der Abdeckfolie. Besondere räumliche Gegebenheiten können jedoch dazu führen, daß ein Winkel in dem zuvor genannten Bereich gewählt werden muß, wobei jetzt die ungünstigeren Kräfteverhältnisse durch einen abgehobenen Flüssigkeitsdruck ausgeglichen werden können.

Bevorzugt werden Vorrichtungen, bei denen die Trägerplatten mit ihrer Längsseite parallel zur Transportrichtung in die Ablösevorrichtung eingefördert werden. Hierbei empfiehlt es sich, quer zur Transportrichtung der Trägerplatten in gleichbleibendem Abstand mehrere Düsen anzuordnen, so daß im wesentlichen gleichzeitig die Kante der Abdeckfolie in ihrer gesamten Breite abgehoben wird. Der optimale Düsenabstand beträgt je nach Strahlbreite der Düsen und je nach Abstand der Düsenöffnungen zur Transportebene 5 bis 20 mm.

Ein bevorzugter Abstand der Düsenöffnung zur Transportebene beträgt zirka 5 bis 20 mm.

Bevorzugt wird bei der erfindungsgemäßen Vorrichtung die Trägerplattenvorrichtung mit einem Sensor zur Positionserkennung der Trägerplatten in Transportrichtung ausgestattet. Von dem Signal dieses Sensors lassen sich eine Reihe von Steuersignalen ableiten, wie im folgenden gezeigt werden wird.

Bei besonders bevorzugten Vorrichtungen wird zusätzlich die Folientransportvorrichtung mit einem Sensor ausgestattet, der ein Druckluft-, ein optischer oder ein sonstiger gebräuchlicher Sensor sein kann, der auf die Gegenwart einer Folie in der Folientransportvorrichtung anspricht.

Solchermaßen ausgestattete Vorrichtungen zum Ablösen von Abdeckfolien lassen sich dann zusätzlich mit einer Austaktvorrichtung kombinieren, die in Transportrichtung stromabwärts von der eigentlichen Ablösevorrichtung angeordnet ist und die in Abhängigkeit der Signale der Sensoren der Trägerplattenfördervorrichtung und der Folientransportvorrichtung aktiviert werden kann. Stellt die Auswerteschaltung, die diese beiden Signale als Eingangssignale erhält, fest, daß eine Trägerplatte die Ablösevorrichtung passiert hat, ohne daß die Abdeckfolie korrekt abgehoben und abgelöst wurde, so wird ein Austaktsignal erzeugt und die die Auslösevorrichtung verlassende Trägerplatte wird von der Austaktvorrichtung aus dem normalen Produktionsprozeß ausgeschleust.

Bevorzugte Vorrichtungen werden mit einer Ablösevorrichtung sowohl für die Ober- als auch die Unterseite der Trägerplatte ausgestattet, so daß in einem Arbeitsgang die Abdeckfolien sowohl von der Ober- als auch der Unterseite der Trägerplatten abgezogen werden können. Da sich jedoch die Hochdruckflüssigkeitsdüsen nur unter größerem Aufwand so exakt positionieren und einstellen lassen, daß sich die vertikalen Kraftkomponenten, die durch die Hochdruckstrahlen auf die Trägerplatten wirken, ausgleichen, wird man die Hochdruckdüsen entsprechend in Transportrichtung versetzt anordnen. Um die Trägerplatten an der Stelle abzustützen, an der die Hochdruckflüssigkeitsstrahlen auf die Platten treffen, wird bei bevorzugten Vorrichtungen jeweils ein Gegenlager für die Trägerplatten vorgesehen. Da bei der Verwendung von Hochdruckflüssigkeitsstrahlen zum Abheben der Abdeckfolie ein relativ hoher Flüssigkeitsdurchsatz erreicht wird, ist es vorteilhaft, insbesondere um die Dimensionierung der Abflüsse für die Flüssigkeit klein zu halten, wenn man in Abhängigkeit der Position der Trägerplatte in Transportrichtung das Flüssigkeitsfördersystem von Hochdruck auf Niederdruck bzw. umgekehrt schalten kann.

Eine solche Vorrichtung erlaubt, unter Ausnützung des von dem Sensor der Trägerplattenfördervorrichtung gegebenen Signals den Flüssigkeitshochdruck exakt zu dem Zeitpunkt anzuschalten, an dem die Vorderkante der Abdeckfolie in der Ebene der Flüssigkeitsstrahlen anlangt. Der Flüssigkeitshochdruck wird von diesem Zeitpunkt an so lange beibehalten, bis die Vorderkante der Abdeckfolie so weit abgehoben ist, daß diese sicher von der Folientransportvorrichtung erfaßt werden kann und aus der Ablösevorrichtung entfernt wird. Von diesem Zeitpunkt ab jedoch ist es ausreichend, die Flüssigkeitsdüsen mit Niederdruck, d.h. mit einem Druck bis zirka 5 bar in Abhängigkeit von dem zu bearbeitenden Material zu betreiben, so daß für den Ablöseprozeß der Folie insgesamt ein wesentlich verringerter Flüssigkeitsdurchsatz anfällt.

Eine wesentliche Verbesserung erfährt die erfindungsgemäße Vorrichtung dadurch, daß die Ablösevorrichtung mit einer Bürstenwalze ausgestattet wird, die quer zur Transportrichtung der Trägerplatte und stromaufwärts von den Flüssigkeitsdüsen sowie benachbart zur Transportebene der Trägerplatten angeordnet wird und die entgegen der Transportrichtung der Trägerplatten drehend antreibbar ist.

Dem Einsatz der Bürstenwalze bei der Entfernung der Abdeckfolie aus der Ablösevorrichtung kommt eine eigenständige erfinderische Bedeutung zu, da diese eine wesentliche Verbesserung der Folientransportvorrichtung, wie sie aus dem Stand der Technik bekannt ist, darstellt. Vorzugsweise wird die Bürstenwalze so in einem Abstand zur Transportebene der Trägerplatten angeordnet, daß zwischen dem Walzenumfang der Bürstenwalze und der Trägerplattenoberfläche ein Abstand eingehalten wird, der maximal 4 mm betragen soll.

Durch die Einhaltung eines gewissen Abstands zwischen Walzenumfang und die Trägerplattenoberfläche werden auch sehr empfindliche Fotolacke vor Beschädigungen bewahrt.

Zweckmäßigerweise wird die Bürstenwalze mit einer Umfangsgeschwindigkeit antreibbar sein, die betragsmäßig größer ist als die Transportgeschwindigkeit der Trägerplatten selbst, so daß die abgelöste Folie durch die Bürstenwalze straff gehalten und in glattem Zustand der Folientransportvorrichtung zugeführt wird.

Eine sehr kompakte Bauweise läßt sich dadurch erreichen, daß man die Bürstenwalze aus mehreren Bürstensegmenten aufbaut, die auf ihrer Welle in Abständen angeordnet sind. Die Abstände, die sich zwischen den Bürstensegmenten quer zur Transportrichtung ergeben, können für eine Montage der Hochdruckdüsen genutzt werden, so daß die Düsen und deren Wirkungsbereich sehr nahe an die von den Bürstenfasern erreichten Bereiche heranreichen. Dadurch können bereits geringfügig abgelöste Abdeckfolien bereits von den Bürstenfasern erfaßt und in Richtung zur Folientransportvorrichtung befördert werden. Die Zeitspanne, in der die Ablösevorrichtung mit Flüssigkeitshochdruck gefahren werden muß, verringert sich dementsprechend.

Bei einer besonders bevorzugten Ausführungsform der Erfindung umfaßt die Folientransportvorrichtung eine Abziehwalze, die in federndem Kontakt mit den durch die Vorrichtung durchlaufenden Trägerplatten steht. Die Kontaktstelle der Abziehwalze mit den Trägerplatten definiert die Stelle in Transportrichtung der Trägerplatten in der Vorrichtung gesehen, an der die Folie von den Trägerplatten frühestens abgelöst wird. Dadurch, daß sich die bereits abgelöste Folie um die Abziehwalze legen kann und in eine Art Haftkontakt mit der Abziehwalze gerät, unterstützt die Abziehwalze in ihrer Drehbewegung das Ablösen der Folie von den Trägerplatten.

Vorzugsweise ist die Abziehwalze mit einer Gummilage belegt, wobei für den Gummi insbesondere Gummisorten mit der Shore-Härte A von zirka 40 Verwendung finden.

Die Umfangsgeschwindigkeit der Abziehwalze wird zweckmäßigerweise gleich der Transportgeschwindigkeit der Trägerplatten gewählt, so daß einmal die Abziehwalze als Schleppwalze betrieben werden kann und außerdem die Folie mit der Geschwindigkeit, mit der sie von der Trägerplatte abgelöst wird, auch von dieser abgehoben und der Folientransportvorrichtung zugeführt wird.

Die Umlenkwalze kann dabei gleichzeitig eine Umlenkachse für die Folientransportvorrichtung bilden.

Dabei ist es nicht notwendig, daß die Abziehwalze aus einer gleichförmigen Fläche in der gesamten Breite der abzulösenden Folien ausgebildet ist, vielmehr ist es durchaus möglich, daß die Abziehwalze auf ihrer Welle mehrere Gummiwalzensegmente trägt, zwischen denen leerlaufende Röllchen angeordnet sind.

Über diese Röllchen können dann Transportriemen der Folientransportvorrichtung geführt werden, wobei die Abziehwalze gleichzeitig die Umlenkung der Transportrichtung der Transportriemen bewirkt. Damit wird eine besonders gute Übergabe von der Abziehwalze zu dem restlichen Teil der Folientransportvorrichtung erreicht, insbesondere verhindern die Transportriemen, daß sich die Folie auf der Abziehwalze aufwickelt.

Die Folientransportvorrichtung umfaßt an ihrem oberen Ende eine obere Umlenkwalze, über die die Transportriemen in Richtung zur unteren Umlenkwalze, die identisch mit der Abziehwalze sein kann, umgelenkt werden. Die obere Umlenkwalze kann dabei eines oder mehrere Gummiwalzensegmente umfassen.

Vorzugsweise wird die Oberfläche der oberen Umlenkwalze der Folientransportvorrichtung eine Struktur aufweisen, die ein Ablösen der Folie von der Umlenkwalze und ein Zuführen zu der Aufwickelwalze oder dem Aufwickelkern erleichtert.

Zweckmäßig ist es dabei, wenn die Struktur auf der Oberfläche der oberen Umlenkwalze im Querschnitt sägezahnförmig ist. Gleichwertig hiermit ist die Ausbildung einer Noppenstruktur auf der Oberfläche der oberen Umlenkwalze oder eine andere Art der Struktur, die die Kontaktfläche von Folie und Walze reduziert und die Adhäsion zwischen Folie und Walze damit vermindert.

Die Aufwickelwalze bzw. der Wickelkern der Aufwickelvorrichtung ist vorzugsweise durch die obere Umlenkwalze der Folientransportvorrichtung antreibbar.

Die benachbart zur Aufwickelvorrichtung angeordnete Bürstenwalze wird zweckmäßigerweise mit einer Rotationsgeschwindigkeit betrieben, die in Umfangrichtung etwas größer ist als die Transportgeschwindigkeit der Folientransportvorrichtung, so daß die Folie auf dem Wickelkern durch die Bürstenwalze glattgestrichen wird.

Bei der besonders rationellen Vorrichtung zum Ablösen der Folien ist vorgesehen, daß die Trägerplatte in einem Durchlauf von der oben und unten anhaftenden Folie befreit wird. Wegen der durch die Flüssigkeitsstrahlen auf die Trägerplatte wirkenden Kräfte und die dabei zweckmäßigerweise anzubringenden Stützvorrichtungen wird man üblicherweise so vorgehen, daß die beiden Ablösevorrichtungen in Transportrichtung der Trägerplatten gesehen gegeneinander versetzt angeordnet sind. Damit vermeidet man, daß die Kräfte der Flüssigkeitsstrahlen der beiden Ablösevorrichtungen gegeneinander austariert sein müssen, um ein Verbiegen der Trägerplatte zu vermeiden.

Die Folientransportvorrichtung wird zweckmäßigerweise durch ein Transportriemensystem gebildet, welches vorzugsweise aus parallel geführten O-Ringen besteht. Die zu transportierenden Folien haften aufgrund des ihnen meist noch anhaftenden Wassers an den Transportriemen und werden so sicher befördert. Vorzugsweise wird die Geschwindigkeit, mit der die Transportriemen umlaufen, mindestens gleich groß wie die Umfangsgeschwindigkeit der Bürstenwalzen gewählt oder aber, um den straffungseffekt in Transportrichtung zu vergrößern, etwas gegenüber der Umfangsgeschwindigkeit der Bürstenwalze erhöht.

Mit einem besonders ausgestalteten Transportriemensystem kann zusätzlich für eine Straffung der Folie quer zur Transportrichtung gesorgt werden, in dem die Transportriemen fächerförmig in Transportrichtung auseinanderlaufend angeordnet werden. Ein solches Folientransportsystem stellt sicher, daß die Folie sowohl in Längs- als auch in Querrichtung gestrafft einem sich der Folientransportvorrichtung anschließenden Aufwickelsystem zugeführt wird. Eine solche Aufwickelvorrichtung besteht aus einem Wickelkern, der die aus der Folientransportvorrichtung ankommende Abdeckfolie aufnimmt und aufwickelt. Dies stellt eine sehr kompakte Möglichkeit zur Entsorgung der Abdeckfolie dar, da hier ein sehr günstiges Raumgewicht erzielt wird. Auch bei der Aufwickelvorrichtung ist es wiederum sehr vorteilhaft, eine Bürstenwalze zu integrieren, die die aus der Folientransportvorrichtung kommende Abdeckfolie zum Wickelkern der Aufwickelvorrichtung umlenkt. Die immer noch an der Folie anhaftende Feuchtigkeit reicht in der Regel für eine genügende Adhäsion der Folie an dem Wickelkern aus, damit dieser die ankommende Folie sicher aufnehmen kann.

Um zu verhindern, daß die Abdeckfolie an der oberen Umlenkwalze der Folientransportvorrichtung ebenfalls umgelenkt wird und mit den Transportriemen wieder in den Bereich der Ablösevorrichtung transportiert wird, kann vorgesehen sein, daß die Umlenkwalze eine Oberflächenstruktur erhält, die die Adhäsion der Folie an der Walze verringert und außerdem den Fasern der Bürstenwalze erlaubt, unter die Abdeckfolie zu greifen und diese zum Wickelkern hin umzulenken.

In den Fällen, in denen die Abdeckfolie am Ende der Folientransportrichtung bereits zu trocken geworden ist, kann eine zusätzliche Vernebelungsdüse vorgesehen sein, deren Strahl gegen den Aufwickelkern gerichtet ist und die Funktion der Bürstenwalze unterstützt und außerdem die erforderliche Feuchtigkeit für eine Adhäsion der Abdeckfolie an dem Wickelkern liefert.

Vorzugsweise wird die Welle des Wickelkerns in einer spaltförmigen Führung geführt und von der oberen Umlenkwalze als Schleppwalze angetrieben. Der Wickelkern wird sich nun stets, auch bei zunehmendem Umfang, mit konstanter Umfangsgeschwindigkeit drehen, da er ja an seinem Umfang von der Umlenkwalze angetrieben wird. Die Drehachse des Wickelkerns wird sich mit wachsender Beladung mit Abdeckfolie immer mehr von der Drehachse der Umlenkwalze entlang der spaltförmigen Führung der Welle entfernen, bis eine maximale Beladung des Wickelkerns erreicht ist und dieser ausgetauscht werden muß.

Um die Betriebssicherheit der erfindungsgemäßen Vorrichtung weiter zu erhöhen, hat es sich als zweckmäßig erwiesen, an all den Stellen des Transportweges der Abdeckfolie Abweiser anzubringen, an denen die Transportrichtung der Folie sich ändert, wobei die Abweiser dafür sorgen, daß die Folie in die neue Transportrichtung umgelenkt wird und nicht beispielsweise an Umlenkrollen kleben bleibt und zu einer Störung des Betriebsablaufs führt.

Diese und weitere Vorteile der Erfindung werden im folgenden an Hand der Zeichnung noch näher erläutert.

Es zeigen im einzelnen:
- Fig. 1: eine Ansicht einer erfindungsgemäßen Folienablösevorrichtung;
- Fig. 2: eine Schnittansicht längs Linie 2-2 in Fig. 1;

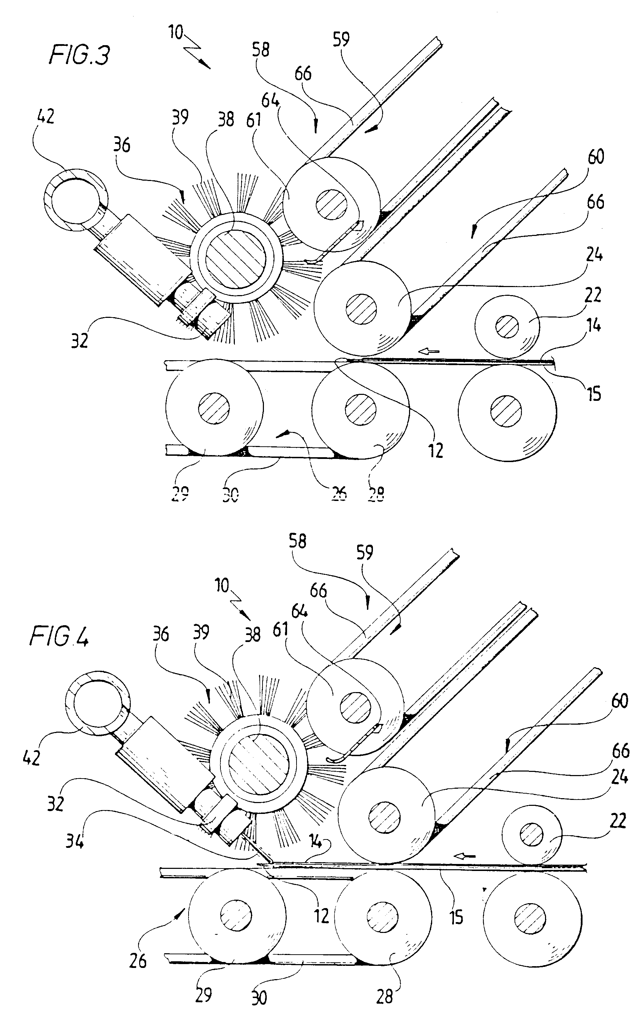

- Fig. 3-8: ein Detail aus der Schnittansicht gemäß Fig. 2, wobei ein fortschreitender Ablöseprozeß der Abdeckfolie gezeigt ist;
- Fig. 9: Schnittansicht durch eine Folienaufwickelwalze;
- Fig. 10: schematische Seitenansicht einer Aufwickelvorrichtung.

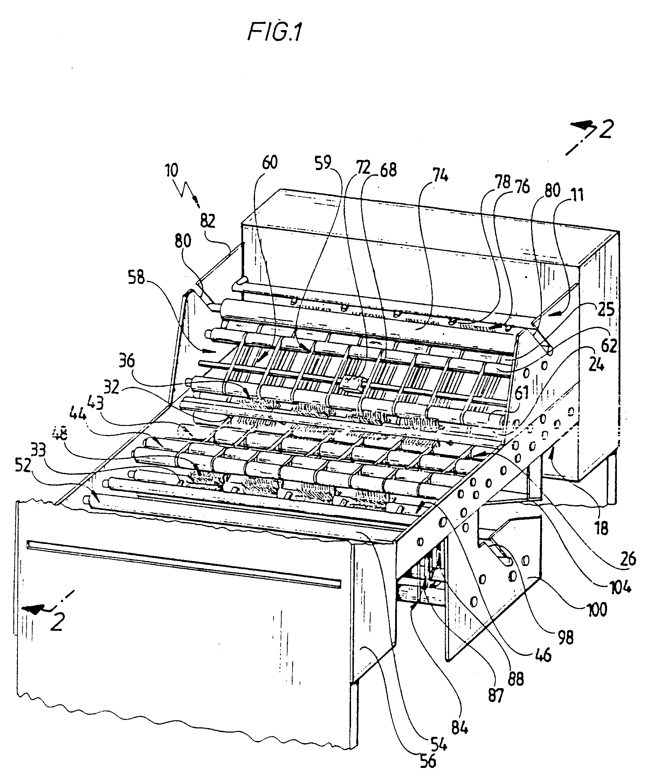

Fig. 1 zeigt die Ansicht einer erfindungsgemäßen Vorrichtung zum Ablösen von Abdeckfolien von plattenförmigen Trägern, wie sie insbesondere bei der Herstellung von Leiterplatten Verwendung finden, bei denen eine Schutzfolie von einer mit einem Fotoresistlack überzogenen Leiterplatte abgelöst werden muß. Die Schutzfolie dient hierbei dem Schutz der sehr empfindlichen Fotolackschicht, die in diesem Verfahrensstadium bereits belichtet ist und die nach dem Ablöseprozeß einer Entwicklung unterzogen wird.

Wegen der heute üblichen sehr geringen Breiten der Leiterbahnen und der ebenfalls sehr geringen Abstände, in denen bei hochintegrierten Schaltkreisen die Leiterbahnen gegeneinander geführt werden, ist eine sehr schonende Behandlung der Leiterplatten in diesem Stadium besonders wichtig, da diese bereits eine längere Behandlung hinter sich haben und einen entsprechend hohen Wert aufweisen. Eine nicht abgelöste oder nur unvollständig abgelöste Folie, die auf der Trägerplatte verbleibt, wenn diese dem nachfolgenden Entwicklungsprozeß zugeführt wird, macht diese für die weitere Verwendung völlig wertlos, da eine beispielsweise nur einseitig entwickelte Trägerplatte nicht erneut dem Entwicklungsprozeß zugeführt werden kann.

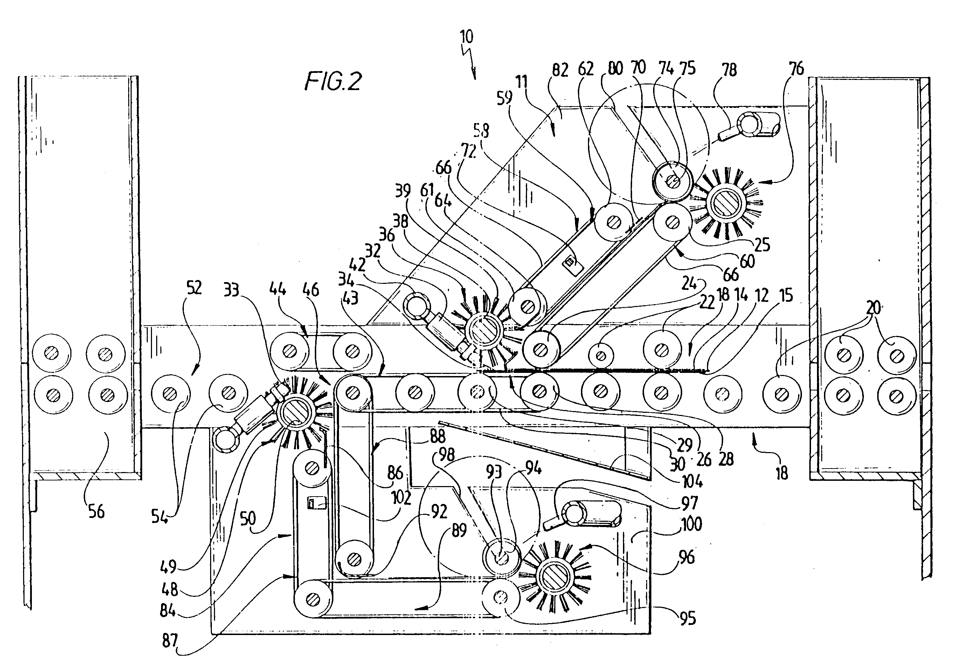

Gegenüber dem ganzen bisher bekannten Stand der Technik, der sich mit der Ablösung von solchen Schutzfolien von plattenförmigen Trägern befaßt, ist die vorliegende Lösung diejenige, die die Leiterplatten am schonendsten behandelt und zudem die größte Sicherheit bezüglich der Ablösung der Folie bietet. Die in den Fig. 1 und 2 gezeigten Ablösevorrichtungen sind so ausgestaltet, daß sie in einem Arbeitsgang die an der Ober- und Unterseite der Leiterplatte 12 vorhandenen Schutzfolien 14, 15 entfernt.

Die Leiterplatten 12 laufen dabei mit einer Fördergeschwindigkeit bis zu 5 m/min über einen Einlauftisch 18 in die eigentliche Ablösevorrichtung 10 ein, wobei Transportwalzen 20 eine Transportebene für die Leiterplatten 12 bilden. Im Bereich der eigentlichen Ablösevorrichtung 10, benachbart zu der Position in Transportrichtung, an der eine Ablösung der Schutzfolie 14, 15 stattfindet, wird die Leiterplatte durch parallel zu den Transportwalzen 20 oberhalb der Transportebene angeordnete Schleppwalzen 22, die auf der Leiterplattenoberfläche federnd anliegen, zusätzlich geführt. Die Transport- und Schleppwalzen weisen im wesentlichen eine glatte Umfangsfläche auf, die mit einem relativ weichen Gummi belegt ist, beispielsweise Gummi der Shore-Härte A 40.

Stromabwärts in Transportrichtung schließt sich an die Transport-/Schleppwalzenkombinationen 20, 22 eine Abziehwalze 24 an, die federbelastet auf der Leiterplatte 12 aufliegt. Unterhalb der Abziehwalze 24 ist ein Gummibandtransportsystem 26 angeordnet, das die Trägerplatte 12 großflächig stützt. Das Gummibandtransportsystem besteht aus zwei Führungswalzen 28, 29 sowie mehreren um diese geführte Gummibänder 30.

Das Gummibandtransportsystem 26 stützt die Leiterplatte 12 exakt in dem Bereich, in dem aus den oberhalb der Transportebene der Leiterplatten angeordneten Hochdruckflüssigkeitsstrahldüsen 32 die Hochdruckflüssigkeitsstrahlen 34 auf die Leiterplatte treffen.

Parallel zu den Führungswalzen des Gummibandtransportsystems ist ebenfalls oberhalb der Transportebene der Leiterplatten 12 eine Bürstenwalze 36 angeordnet, bei der auf einer Welle 38 auf deren Länge verteilt mehrere Bürstensegmente 39 in Abständen angeordnet sind. In den zwischen den Bürstensegmenten 39 verbleibenden Zwischenräumen lassen sich die Hochdruckdüsen 32 anordnen, so daß eine sehr kompakte Bauweise erreicht werden kann. Die Hochdruckdüsen 32 werden mit der Flüssigkeit über eine gemeinsame Rohrleitung 42 versorgt, die sich quer zur Transportrichtung über die gesamte Breite der Ablösevorrichtung erstreckt.

Die Hochdruckdüsenanordnung 32 bildet zusammen mit der Bürstenwalze 36 den eigentlichen Kern der Ablösevorrichtung, wobei die Hochdruckdüsen 32 an sich für eine Ablösung der Abdeckfolie ausreichend sind, die Bürstenwalze 36 jedoch für eine wesentliche Verbesserung des Ablöseprozesses sorgt, insbesondere dadurch, daß die Folie in glattem Zustand aus dem Bereich der Ablösevorrichtung abtransportiert wird.

Weiter stromabwärts, in Transportrichtung gesehen, wird die Leiterplatte 12 von weiteren Riementransportsystemen 43, 44 gestützt und transportiert, wobei dem Riementransportsystem 44, das oberhalb der Transportebene der Leiterplatten 12 angeordnet ist, die entsprechende Funktion des Gummibandtransportsystems 26 zukommt, da unterhalb des Riementransportsystems 43 eine weitere Ablösevorrichtung 46 angeordnet ist, die die untere Schutzfolie 15 von der Leiterplatte 12 entfernt. Diese Ablösevorrichtung 46 setzt sich in gleicher Weise wie die zuvor beschriebene Ablösevorrichtung zusammen. Auch hier wird über Hochdruckdüsen 33 ein Hochdruckflüssigkeitsstrahl gegen die Leiterplatte gespritzt, sobald sie den Wirkbereich der Hochdruckdüsen 33 erreicht. Entsprechend wird die unterhalb der Leiterplatte angeordnete Bürstenwalze 48 für das sichere Abführen der teilweise abgelösten Folie aus dem Bereich der Ablösevorrichtung 46 sorgen.

Die Bürstenwalze 48 besteht ebenfalls aus einer Welle 49 und darauf befestigten Bürstensegmenten 50, wie dies bereits bei der Bürstenwalze 36 beschrieben wurde. Die Hochdruckdüsen 33 sind wiederum in den zwischen den Bürstensegmenten verbleibenden Abständen angeordnet, so daß sich auch bei der Ablösevorrichtung 46 eine kompakte Bauweise ergibt.

In Transportrichtung der Trägerplatten stromabwärts ist nach der Ablösevorrichtung 46 ein weiteres Trägerplattentransportsystem 52 angeordnet, das über Förderwalzen 54 die von den Abdeckfolien 14, 15 befreiten Leiterplatten der nächsten Verarbeitungsstation 56 zuführt, die nur schematisch dargestellt ist.

Im folgenden sei zunächst die Vorrichtung zum Abtransportieren der von der Trägerplatte 12 abgelösten Folie 14 beschrieben.

Die aus den Düsen 32 austretenden Hochdruckflüssigkeitsstrahlen 34 sind bei der Ankunft der Leiterplatte 12 zunächst gegen die in Transportrichtung gesehen vordere Kante der Abdeckfolie 14 gerichtet und heben diese im wesentlichen über ihre gesamte Breite gleichmäßig ab. In dem sich zwischen Folie 14 und Leiterplatte 12 bildenden Spalt bildet sich durch die von den Düsen 32 gelieferte Flüssigkeit ein Flüssigkeitskeil, der zu einer weiteren Ablösung der Folie 14 von der Leiterplatte 12 führt, wobei sich die Ablösestelle von dem Schnittpunkt des Hochdruckstrahls mit der Transportebene der Leiterplatten 12 stromaufwärts verschiebt, bis die Folie 14 an der Abziehwalze 24 zum Anliegen kommt.

Sobald durch die Hochdruckstrahlen 34 ein ausreichender Teil der Abdeckfolie 14 abgelöst ist, so daß dieser Teil sicher von einer oberhalb der Transportebene angeordneten Folientransportvorrichtung erfaßt werden kann, werden die Düsen nur noch mit niedrigem Flüssigkeitsdruck betrieben, da von diesem Zeitpunkt an nur noch eine Unterstützung des Ablöseprozesses durch die Düsenstrahlen notwendig ist.

Die Folientransportvorrichtung wird in dem in den Figuren gezeigten Beispiel durch zwei Riementransportsysteme gebildet, die beidseits einer Folientransportebene angeordnet sind und die die Folie 14 auf ihrer Ober- und Unterseite erfassen.

Die beiden Riementransportsysteme 59, 60 bestehen im wesentlichen aus zwei Umlenkwalzen 24, 25 bzw. 61, 62, wobei die untere Umlenkwalze des Riementransportsystems 59 identisch mit der Abziehwalze 24 ist. Das Riementransportsystem definiert eine Folientransportrichtung, die in spitzem Winkel gegen die Leiterplattentransportrichtung geneigt ist und führt die Folie 14 nach oben hin aus dem Bereich der eigentlichen Ablösevorrichtung ab. Die Zuführung der Folie 14 zur Folientransportvorrichtung 58 wird entscheidend durch die Bürstenwalze 36 verbessert, die in einem Abstand, der jedoch sehr klein gehalten wird, zu der Leiterplattenoberfläche angeordnet ist. Dadurch kann die Bürstenwalze 36 die von den Hochdruckstrahlen 34 angehobene Folie 14 bereits in einem Anfangsstadium der Ablösung erfassen und so das weitere Ablösen der Folie 14 und das stromaufwärts Wandern des Ablösepunktes unterstützen.

Der Ablösepunkt wandert so lange stromaufwärts, bis sich die Folie um die Abziehwalze 24 legt. Da die Folie an ihrer Oberseite benetzt ist, ergibt sich eine Adhäsion an die mit Gummi belegte Abziehwalze 24, was das weitere Ablösen der Folie unterstützt. Gleichzeitig bildet die Abziehwalze für die Wasser- oder Flüssigkeitsstrahlen eine Barriere, die das Ausbreiten der Flüssigkeit in weitere Bereiche der Ablösevorrichtung weitestgehend unterbindet.

Um zu verhindern, daß die Folie 14 sich um die Bürstenwalze 36 wickelt, sind zwischen den Bürstensegmenten 39 der Bürstenwalze 36 Abweiser 64 vorgesehen, die in Form von schmalen Blechstreifen, deren vorderes zur Bürste hin orientierte Ende leicht gekröpft ist, bis in den Bereich der Bürstenfasern hineinragen, während der Blechstreifen 64 sonst im wesentlichen parallel zur Folientransportrichtung in der Folientransportvorrichtung 58 angeordnet ist.

Um die Umlenkwalzen 24, 25 bzw. 61, 62 der Riementransportsysteme 59, 60 sind als Transportriemen 66 in der Regel O-Ringe geführt, die in ihrer Position quer zur Transportrichtung durch Kunststoffröllchen 68 geführt werden. Die auf der Abzieh- oder Umlenkwalze 24 angeordneten Röllchen 68 sind zwischen Gummiwalzenelemente dieser Abziehwalze freilaufend montiert, so daß die Transportgeschwindigkeit des Riementransportsystems 59 unabhängig von der Umfangsgeschwindigkeit der Abziehwalze 24 gewählt werden kann. Das Riementransportsystem 59 wird über die Umlenkwalze 25 angetrieben, bei der die Röllchen 68 drehfest auf der Umlenkwalzenwelle befestigt sind. Das Riementransportsystem 60 wird mit der gleichen Geschwindigkeit angetrieben wie das Riementransportsystem 59, um einen gleichmäßigen Transport der Folie 14 zu gewährleisten.

Auch im Riementransportsystem sorgt die Benetzung der Folie für Adhäsionskräfte zwischen Folie und Transportriemen, so daß ein sicherer Transport der Folie resultiert.

Am oberen Ende des Riementransportsystems 60 ist wieder ein Abweiser 70 angeordnet, der verhindert, daß die Folien 14 unter ungünstigen Bedingungen um die Umlenkwalze 62 umgelenkt und durch die zurücklaufenden Transportriemen 66 des Riementransportsystems 60 wieder in den Bereich der Bürste bzw. der Ablösevorrichtung zurücktransportiert werden.

Etwa mittig zur Transportstrecke der Folientransportvorrichtung 58 ist ein Sensor 72 angeordnet, der auf das Vorhandensein der Folie 14 anspricht. Dieser Sensor 72 kann beispielsweise in Form eines Druckluftsensors oder auch in Form eines optischen Sensors ausgeführt sein.

Am oberen Ende der Folientransportvorrichtung 58 und parallel zur Umlenkwalze 25 ist dann eine Aufwickelwalze 74 angeordnet, die mit ihrem Umfang auf der Umlenkwalze 25 aufliegt und von dieser die Folie 14 übernimmt. Normalerweise wird der Benetzungsgrad der Folie 14 ausreichend sein, um zu einer guten Adhäsion der Folie 14 an der Oberfläche der Aufwickelwalze 74 zu führen, so daß die Folie 14 von der zur Umlenkwalze 25 gegensinnig rotierenden Aufwickelwalze 74 mitgenommen zu werden.

Eine parallel zur Umlenkwalze 25 und zur Aufwickelwalze 74 angeordnete weitere Bürstenwalze 76, die gleichsinnig mit der Umlenkwalze 25 rotiert, verhindert, daß unter ungünstigen Bedingungen die Folie 14 über die Umlenkwalze 25 umgelenkt und wieder in den Bereich der Ablösevorrichtung transportiert wird. Die Bürstenwalze 76 hat daneben die weitere Funktion, die Folie 14 am Umfang der Aufwickelwalze 44 glattzustreichen, so daß sich ein sehr sauberer und glatter Folienwickel ergibt, wobei eine maximale Speicherkapazität der Aufwickelwalze 74 garantiert wird.

Um einen ausreichenden Benetzungsgrad der Folie 14 sicherzustellen, kann man oberhalb der Bürstenwalze 76 und der Aufwickelwalze 74 eine oder mehrere Vernebelungsdüsen 78 anordnen, wie sie in Fig. 2 nur schematisch angedeutet sind. Die Vernebelungsdüsen 78 werden dabei bevorzugt so angeordnet, daß sie in etwa in radialer Richtung zur Aufwickelwalze 74 strahlen, wobei bei einem der Bürstenwalze 36 entsprechenden Aufbau der Bürstenwalze 76 die Vernebelungsdüsen zwischen den einzelnen Bürstensegmenten der Bürstenwalze 76 angeordnet werden können. Dadurch erhält man zusätzlich den Effekt, daß ein Umwickeln der Bürstenwalze 76 durch die Folie 14 verhindert wird und der Effekt der Bürstenwalze 76, d.h. das Andrücken der Folie 14 an die Aufwickelwalze 74 unterstützt und verstärkt wird.

Die Aufwickelwalze 74 fungiert als Schleppwalze für die Umlenkwalze 25, was den Vorteil hat, daß die Umfangsgeschwindigkeit der Aufwickelwalze 74 auch bei zunehmendem Beladungsgrad der Aufwickelwalze, d.h. auch bei zunehmendem Radius, stets konstant und identisch mit der Transportgeschwindigkeit des Folientransportsystems 58 gehalten wird. Um ein Ausweichen der geometrischen Drehachse der Aufwickelwalze 74 zu ermöglichen und trotzdem zu gewährleisten, daß die Umlenkwalze 25, die Bürstenwalze 76 und die Aufwickelwalze 74 stets miteinander in Berührungskontakt bleiben, ist für die Welle 75 der Aufwickelwalze 74 eine spaltförmige Führung 80 vorgesehen, die beispielsweise von den Gehäusewandungen 82 gebildet werden kann.

Bei den gezeigten Radienverhältnissen von Umlenkwalze 25 und Bürstenwalze 76 ergibt sich in der gezeigten Konstellation eine im wesentlichen lineare Führung für die Aufwickelwalze 74. Vorteilhaft werden die spaltförmigen Führungen 80 für die Welle 75 nach oben hin offen gelassen, so daß eine voll beladene Aufwickelwalze 74 leicht abgenommen und eine unbeladene Aufwickelwalze 74 in die Apparatur eingesetzt werden kann.

Anschließend an die Ablösevorrichtung 46, die unterhalb der Transportebene der Leiterplatten 12 angeordnet ist, schließt sich eine weitere Folientransportvorrichtung 84 an, die die an der Unterseite der Leiterplatte 12 abgelöste Folie 15 zunächst in einer im wesentlichen vertikalen Richtung nach unten von der Transportebene der Leiterplatten 12 wegführt. Der Ablöseprozeß der Folie 15 von der Leiterplatte 12 wird hier wiederum durch eine Bürstenwalze 48 unterstützt, die umfangsmäßig zwar in einem Abstand zur Leiterplattenoberfläche angeordnet ist, der jedoch so klein gehalten wird, daß bereits eine nur wenig abgehobene Folienkante von der Bürste erfaßt wird und der Folientransportvorrichtung 84 zugeführt wird.

Entsprechend dem Abweiser 64 ist auch zwischen den Bürstensegmenten 49 der Bürstenwalze 48 eine Abweiservorrichtung 86 vorgesehen, die ein Umwickeln der Bürstenwalze 48 durch die Folie 15 verhindert.

Die Folientransportvorrichtung 84 setzt sich im wesentlichen aus drei Riementransportsystemen 87, 88, 89 zusammen, von denen die Transportsysteme 87 und 88 die Folie im wesentlichen vertikal nach unten führen und das Transportsystem 89 die Folie im rechten Winkel dazu umlenkt.

Die Riemen der Riementransportsysteme sind wieder als O-Ringe 90 ausgebildet, und werden wie bei den Riementransportsystemen 59, 60 über Umlenkwalzen und darin integrierte Röllchen geführt. Bei der rechtwinkligen Umlenkung der Folie durch das Riementransportsystem 89 ist wieder ein Abweiser 92 vorgesehen, der verhindert, daß die Folie 15 durch das Riementransportsystem 88 zur Ablösevorrichtung 46 zurückgeführt wird.

Am Ende des Riementransportsystems 89 ist wieder eine Aufwickelwalze 94 vorgesehen, die als Schleppwalze von einer Umlenkwalze 95 des Riementransportsystems 89 umfangsmäßig angetrieben wird.

Durch die Umlenkung der Folie aus der Vertikalen besteht nun die Möglichkeit, die Folienaufwickelvorrichtung in entsprechender Weise wie beim Folientransportsystem oberhalb der Transportebene der Leiterplatten 12 auszubilden. Dies bedeutet, daß entsprechend der zuvor beschriebenen Aufwickelvorrichtung eine Bürstenwalze 96 vorhanden ist, die in ihrer Funktion von Vernebelungsdüsen 97 unterstützt wird. Die Aufwickelwalze 94 wird ebenso wie die Aufwickelwalze 74 durch im wesentlichen geradlinige Führungen 98, die als Spalte in einer Gehäusewandung 100 vorgesehen sind, verschieblich geführt, so daß die Aufwickelwalze 94 mit zunehmendem Beladungsgrad schräg nach oben ausweichen kann. Die Führungen 98 in der Gehäusewandung 100 sind wiederum nach oben vorzugsweise offen gehalten, so daß ein leichtes Austauschen der vollbeladenen Aufwickelwalzen 94 ermöglicht ist.

Auch das untere Folientransportsystem weist einen Sensor 102 auf, der auf das Vorhandensein einer Folie 15 im Folientransportsystem 84 anspricht. Die Arbeitsräume der oberen Folienablösevorrichtung und der unteren Aufwickelvorrichtung werden durch ein Schutzblech 104 getrennt, das das bei der Ablösung der oberen Folie 14 verbrauchte Wasser von der unteren Aufwickelvorrichtung abhält und in den Abfluß des Systems ableitet.

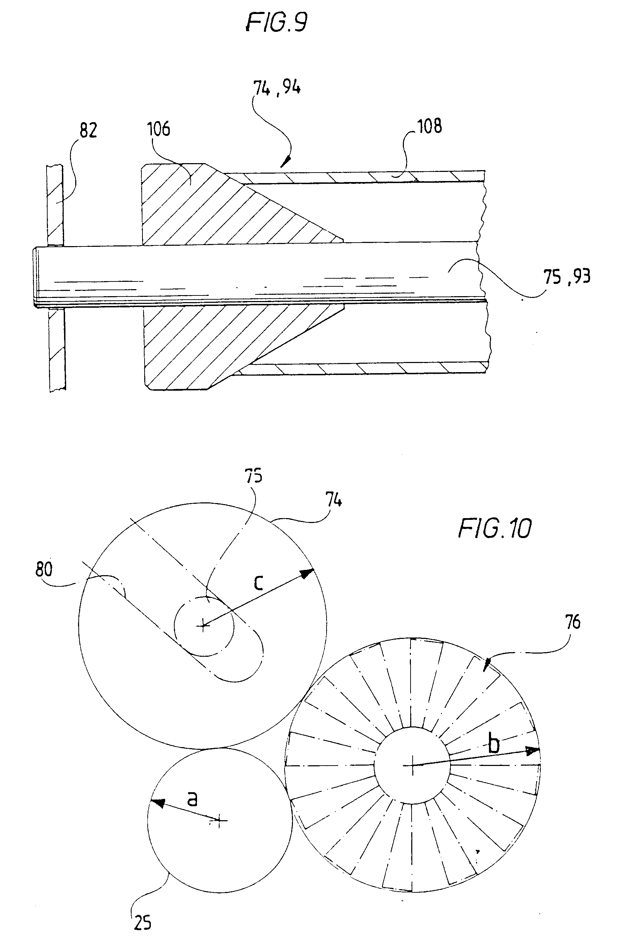

In Fig. 9 ist der genauere Aufbau der Aufwickelwalze 74 oder 94 gezeigt. Die Aufwickelwalzen werden vorzugsweise als separate Welle 75 bzw. 93 aufgebaut, die an ihren Enden aufgeschobene konische Halteteile 106 tragen. Das verjüngte Ende der konischen Halteteile weist dabei zur Wellenmitte. Die Folien selbst werden auf einen Wickelkern 108 aufgewickelt, der in der Regel ein einfaches Kunststoffrohr sein wird, das bei einer vollständigen Beladung der Aufwickelwalze 74, 94 von der Walze entfernt und weggeworfen wird. Dabei ist es vorteilhaft, wenn eines der Halteteile 106 auf der Walze festegelegt ist, während das andere leicht entfernt werden kann.

Durch die konische Ausbildung der Halteteile ist ein rotationssymmetrisches Zentrieren der Wickelkerne 108 in einfacher Weise möglich.

Zur Erzielung einer besonders großen Wartungsfreundlichkeit werden sämtliche Teile der Anlage aus Edelstahl und/oder Kunststoff gefertigt.

Im folgenden wird nun das erfindungsgemäße Verfahren zum Ablösen einer Schutzfolie von einer Leiterplatte 12 beschrieben, wobei sich die Beschreibung auf den Ablöseprozeß der an der Oberseite der Leiterplatte 12 befindlichen Folie 14 beschränkt, da sich der Ablöseprozeß an der Unterseite der Folie prinzipiell nicht unterscheidet.

Die Leiterplatten 12 werden vereinzelt über den Einlauftisch 18 in die eigentliche Ablösevorrichtung eingefördert, wobei in dem Einlaufbereich über einen Sensor die Leiterplattenvorderkante detektiert wird. Sobald die Leiterplatten eine Position erreicht haben, in der die Vorderkante der abzulösenden Folie in den Wirkbereich der Hochdruckstrahldüsen gelangt, wird die Hochdrucksprühvorrichtung mit den Düsen 32 angeschaltet und die vorzugsweise flach strahlenden Düsen heben mit ihren Hochdruckstrahlen die vordere Kante der Folie 14 von der Leiterplatte 12 ab, wobei sich ein Wasserkeil zwischen der Folie 14 und der Leiterplatte 12 bildet, der sich unter dem Einfluß des Hochdruckstrahls weiter stromaufwärts verschiebt und dabei die Folie 14 weiter von der Leiterplatte 12 ablöst. Der Ablöseprozeß wird durch die Bürstenwalze 35 unterstützt, die umfangsmäßig knapp oberhalb der Oberfläche der Leiterplatte 12 angeordnet ist, um einerseits keine Verletzung der nun ungeschützt vorliegenden Fotolackschicht zu bewirken und um andererseits den bereits in Ansätzen abgelösten Folienanfang der Folie 14 ergreifen und in Richtung zur Abziehwalze 24 lenken zu können.

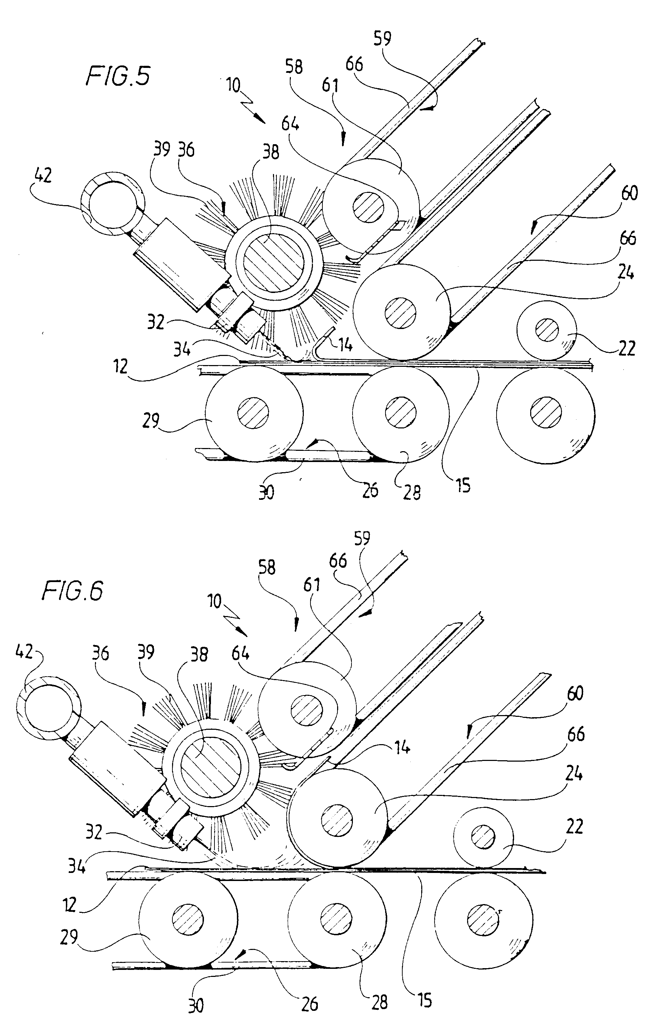

Das Hochdrucksprühen wird nach kurzer Zeit, d.h. nach wenigen Sekunden, die bereits ausreichen, um ein Abheben der Vorderkante der Abdeckfolie zu sichern, auf Niederdruck umgeschaltet, da im folgenden Ablöseprozeß in der Regel ein Flüssigkeitsdruck von 2 - 3 bar ausreicht, um den Ablöseprozeß der Folie von der Leiterplatte 12 zu unterstützen. Die Bürstenwalze 36 legt die Folie 14 um die Abziehwalze 24, wobei durch die vorhandene Feuchtigkeit und Benetzung der Folie 14 eine Adhäsion der Folie an der Abziehwalze entsteht, so daß auch die Abziehwalze, die bevorzugt federnd auf der Leiterplattenoberfläche aufliegt, den Ablöseprozeß der Folie 14 von der Leiterplatte 12 von diesem Augenblick an unterstützt (vgl. Fig. 6). Der Ablösepunkt der Folie liegt nun ziemlich genau in der Ebene, in der die Abziehwalze 24 die Oberfläche der Leiterplatte 12 berührt. Zwischen der Folie und der Leiterplattenoberfläche bildet sich nach wie vor der besagte Flüssigkeitskeil.

Durch das Umschalten von Hochdruck auf Niederdruck läßt sich die Flüssigkeitsmenge, die bei dem Ablöseprozeß verbraucht wird, wesentlich reduzieren, so daß die Abflüsse aus der Vorrichtung relativ kelin gehalten werden können.

Die Abziehwalze wird vorzugsweise mit derselben Umfangsgeschwindigkeit betrieben,wie dies der Transportgeschwindigkeit der Leiterplatten entspricht. Demgegenüber wird bei der Umfangsgeschwindigkeit der Bürstenwalze, die gegensinnig zur Transportrichtung angetrieben wird, betragsmäßig bis zum Zweifachen schneller als die Transportgeschwindigkeit der Leiterplatten gewählt, um so die über die Abziehwalze laufende Folie glattzustreichen.

Im weiteren Verlauf des Ablöseprozesses wird dann die Folie zwischen den Riementransportsystemen 59, 60, deren Transportgeschwindigkeit bevorzugt größer als die Transportgeschwindigkeit der Leiterplatten gewählt wird, jedoch mindestens so groß sein muß wie die Umfangsgeschwindigkeit der Bürstenwalze 36, der Aufwickelwalze 74 zugeführt. Durch die ansteigende Transportgeschwindigkeit wird eine Zugkraft auf die Folie in Transportrichtung ausgeübt, so daß die Folie ohne Falten quer zur Transportrichtung bei der Aufwickelwalze 74 ankommt. In Querrichtung kann eine Faltenbildung weitgehend verhindert oder beseitigt werden, indem man die Riementransportsysteme 59, 60 so ausbildet, daß die Transportriemen 66 fächerförmig, in Transportrichtung gesehen, auseinanderlaufen, so daß Zugkräfte quer zur Transportrichtung auf die Folie ausgeübt werden. Mit diesen Vorkehrungen wird sichergestellt, daß die Folie in absolut glattem Zustand der Aufwickelvorrichtung zugeführt wird, so daß sich ein sehr gleichmäßiger Wickel auf der Aufwikkelwalze 74 ergibt.

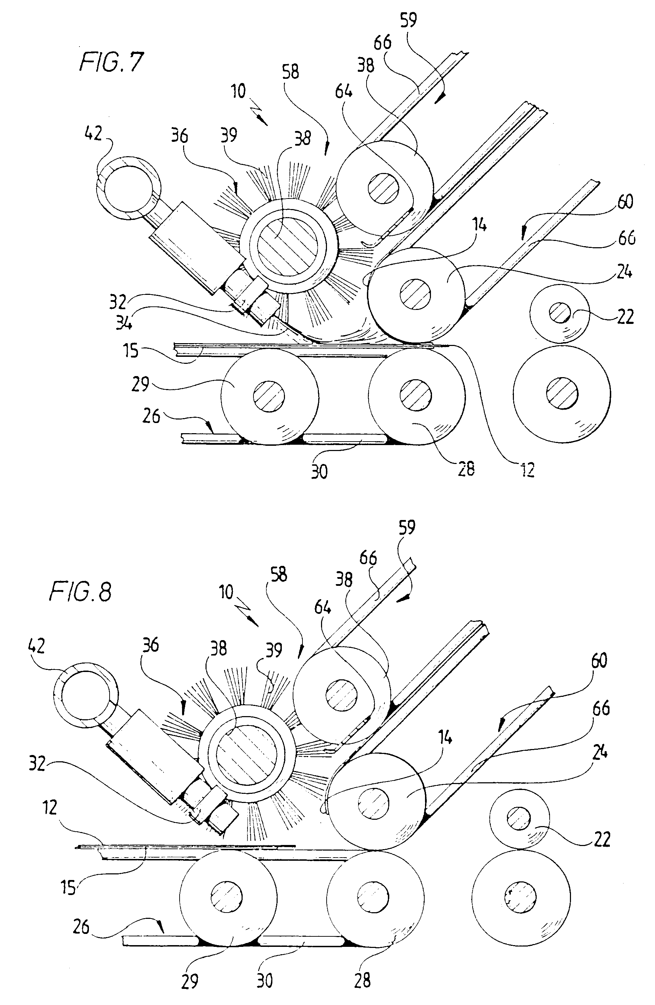

Sobald der letzte Berich der Abdeckfolie von der Leiterplatte abgelöst ist, wird die Flüssigkeitszufuhr zu den Düsen 32 gänzlich abgestellt (vgl. Fig. 8), so daß möglichst wenig Flüssigkeit bei der Ablösung der Folien verbraucht wird.

Die Folie passiert den Sensor 72, wodurch der Steuerung der Gesamtanlage signalisiert wird, daß der Ablöseprozeß an der Oberseite der Leiterplatte 12 zufriedenstellend funktioniert hat.

Die Bürstenwalze 76 leitet die am oberen Ende der Folientransportvorrichtung 58 ankommende Folie 14 zur Aufwikkelwalze 74 um. Bevorzugt wird die Bürstenwalze 76 wiederum mit einer etwas höheren Umfangsgeschwindigkeit betrieben, als es der Folientransportgeschwindigkeit entspricht, so daß die Bürstenwalze 76 die Folie an der Aufwickelwalze 74 anreibt.

Mit zunehmendem Beladungsgrad wird die Aufwickelwalze 74 in der Führung 80 schräg nach oben hin ausweichen, wobei jedoch die Neigung der Führung 80 so gewählt ist, daß stets ein Berührungskontakt der drei Walzen 25, 74 und 76 gegeben ist, so daß die Funktion der jeweiligen Walzen während dem ganzen Prozeßablauf sichergestellt ist.

Figur 10 zeigt schematisch die Anordnung der Walzen 25, 76 und 74 mit ihren Radien a, b und c. Die Führung 80 für die Aufwickelwalze 74 mit ihrem variablen Radius c ist so gegen die Ebene geneigt, in der die geometrischen Drehachsen der Umlenkwalze 25 und der Bürstenwalze 76 liegen, daß der Abstand der geometrischen Drehachse der Aufwickelwalze zur Umlenkwalzenachse stets gleich a + c beträgt und der entsprechende Abstand zur Bürstenwalze stets b + c beträgt. Die geometrische Drehachse der Aufwickelwalze 74 bewegt sich zwar nicht auf einer ebenen Fläche, bei dem gezeigten Radienverhältnis a/b in Figur 10 jedoch kann man in dem durch die Führung 80 definierten Bereich in guter Näherung eine Ebene annehmen, so daß die Führung 80 für die Welle 75 ohne Nachteil geradlinig ausgebildet sein kann. Entsprechendes gilt natürlich für die Aufwickelvorrichtung unterhalb der Transportebene der Trägerplatten.

Der Beladungsgrad der Aufwickelwalze 74 kann durch einen weiteren Sensor überwacht werden, und davon ein Signal abgeleitet werden, das entweder das Bedienungspersonal veranlaßt, die voll beladene Aufwickelwalze 74 gegen eine unbeladene auszutauschen oder aber einen automatischen Austauschmechanismus in Gang setzt.

Wie bereits vorher erwähnt, findet im Prinzip der gleiche Vorgang auch unterhalb der Transportebene der Leiterplatten 12 statt, indem die Düsen 33 dann auf Hochdruck eingeschaltet werden, wenn die Leiterplatte mit ihrem vorderen Ende in den Wirkungsbereich der Hochdruckstrahlen der Düsen 33 gelangt. Wiederum wird der Folienanfang von der Bürstenwalze 48 erfaßt und den Riementransportsystemen 87, 88 zugeführt, welche die Folie dann an das Riementransportsystem 89 übergeben. Von dort gelangt die Folie unter Stützung durch die Bürstenwalze 96 zur Aufwickelwalze 94, die in gleicher Weise wie die Aufwickelwalze 74 in Führungen 98 verschieblich gelagert ist. Wie bereits zuvor erwähnt, sind im Bereich der Aufwickelwalzen und der Bürstenwalzen sowohl bei der Aufwickelvorrichtung unterhalb wie auch oberhalb der Transportebene der Leiterplatten 12 Vernebelungsdüsen 78 bzw. 97 angeordnet, die bei zu geringem Benetzungsgrad der Folien für eine zusätzliche Benetzung der Folien sorgen, so daß diese eine ausreichende Adhäsion an der Aufwickelwalze 94 bzw. 74 zeigen.

Auch die Folientransportvorrichtung unterhalb der Transportebene der Leiterplatten 12 weist einen auf die Folien 15 ansprechenden Sensor 102 auf, so daß über die Auswertung der Signale der Sensoren 72 und 102 kontrolliert werden kann, ob die Leiterplatte 12 von beiden Abdeckfolien befreit wurde. Dies ist von besonderer Wichtigkeit, da nur solche Leiterplatten dem weiteren Entwicklungsprozeß zugeführt werden sollen, bei denen die Abdeckfolien korrekt entfernt worden sind. Die Signale der Sensoren 72 und 102 lassen sich nun zu einem Austaktsignal verknüpfen, das eine Austaktvorrichtung aktiviert, die in den Figuren nicht dargestellt ist. Über die Austaktvorrichtung können dann solche Leiterplatten 12 aus dem Produktionsprozeß ausgetaktet und ausgetragen werden, bei denen eine Ablösung der Folien nicht ordnungsgemäß erfolgt ist. Dadurch läßt sich der Produktionsprozeß ohne Störung weiterführen, selbst wenn im Einzelfall eine Folie von der Leiterplatte nicht oder nur unvollständig entfernt wurde. Der gesamte Vorgang des Ablösens der Folie samt der Kontrolle der Leiterplatten 12 kann, wie gezeigt, vollautomatisch durchgeführt werden, so daß kein Eingreifen von Hand notwendig wird und selbst ein unvollständiges Ablösen von Abdeckfolien keine Produktionsunterbrechung bedeutet.

## Patentansprüche

1. Verfahren zum Ablösen einer Abdeckfolie (14, 15) von einem plattenförmigen Träger (12), insbesondere zum Ablösen eines eine Fotolackschicht auf einer Leiterplatte abdeckenden Schutzfilms, wobei in einem ersten Schritt eine Kante der Abdeckfolie (14, 15) von einer Ablösevorrichtung (10) abgehoben und in einem zweiten Schritt von einer Folientransportvorrichtung (58) erfaßt wird, die die Folie bei fortschreitender Ablösung von dem Träger aus dem Bereich der Ablösevorrichtung entfernt, **dadurch gekennzeichnet**, daß die Kante der Abdeckfolie (14, 15) durch einen oder mehrere Hochdruckflüssigkeitsstrahlen (34) von dem plattenförmigen Träger (12) abgehoben wird.

2. Verfahren nach Anspruch 1, dadurch gekennzeichnet, daß die Flüssigkeit mit einem Druck von zirka 40 bis 60 bar gegen die Kante der Folie (14, 15) gespritzt wird.

3. Verfahren nach einem der Ansprüche 1 oder 2, dadurch gekennzeichnet, daß die Flüssigkeit in Form eines flachen Strahls gegen die Folienkante gespritzt wird, wobei der flache Strahl so orientiert ist, daß die Längsausdehnung des Strahlquerschnitts parallel zur Folienkante verläuft.

4. Verfahren nach einem der voranstehenden Ansprüche, dadurch gekennzeichnet, daß die Kante der Folie (14, 15) auf ihrer gesamten Breite ungefähr gleichzeitig durch mehrere im Abstand auf die Kante treffende Flüssigkeitsstrahlen (34) abgehoben wird.

5. Verfahren nach einem der voranstehenden Ansprüche, dadurch gekennzeichnet, daß der Hochdruckflüssigkeitstrahl (34) nur zum Abheben der Folienkante auf die Abdeckfolie (14, 15) einwirkt, jedoch mindestens so lange, bis diese mit ihrem vorderen Ende von der Folientransportvorrichtung (58) erfaßt wird und daß im Anschluß daran das weitere Ablösen der Folie (14, 15) durch einen Flüssigkeitstrahl (34) mit niederem Druck unterstützt wird.

6. Verfahren nach Anspruch 5, dadurch gekennzeichnet, daß der Flüssigkeitsstrahl (34) für das weitere Ablösen der Folie mit einem Flüssigkeitsdruck von bis zu zirka 5 bar erfolgt.

7. Verfahren nach einem der voranstehenden Ansprüche, dadurch gekennzeichnet, daß die durch den Hochdruckstrahl (34) abgehobene Folie (14, 15) mittels einer entgegen der Transportrichtung der Trägerplatte (12) rotierenden Bürstenwalze (36) der Folientransportvorrichtung (58) zugeführt wird.

8. Verfahren nach einem der voranstehenden Ansprüche, dadurch gekennzeichnet, daß die Transportgeschwindigkeit der Folientransportvorrichtung (58) größer gewählt wird als die Transportgeschwindigkeit der plattenförmigen Träger (12) und gegebenenfalls mindestens gleich groß wie die Umfangsgeschwindigkeit der Bürstenwalze (36).

9. Verfahren nach einem der voranstehenden Ansprüche, dadurch gekennzeichnet, daß die im Bereich der Folientransportvorrichtung (58) befindliche Folie (14, 15) durch quer zur Transportrichtung wirkende Zugkräfte beim Abtransport aus dem Bereich der Ablösevorrichtung 10 geglättet wird.

10. Verfahren nach einem der voranstehenden Ansprüche, dadurch gekennzeichnet, daß die Folie (14, 15) am Ende der Folientransportvorrichtung (58) von einer Aufwickelvorrichtung (74) übernommen wird.

11. Verfahren nach Anspruch 10, dadurch gekennzeichnet, daß die Folie durch eine rotierende Bürstenwalze (76) der Aufwickelvorrichtung (74) zugeführt wird.

12. Verfahren nach einem der voranstehenden Ansprüche, dadurch gekennzeichnet, daß im Bereich der Folientransportvorrichtung (58) über einen Sensor (72) das Ablösen der Folie (14, 15) überwacht wird.

13. Verfahren nach Anspruch 12, dadurch gekennzeichnet, daß das Signal eines Sensors, der die Position des Trägers in Transportrichtung erkennt, mit dem Signal des Sensors (72) der Folientransportvorrichtung (58) zu einem Austaktsignal verknüpft wird, das zum Austragen von Trägerplatten (12) aus dem Produktionsprozeß dient, bei denen die Abdeckfolie (14, 15) nicht korrekt entfernt wurde.

14. Vorrichtung zum Ablösen einer Abdeckfolie von einem plattenförmigen Träger (12), wobei die Vorrichtung eine Fördervorrichtung (18, 26) für die plattenförmigen Träger (12), eine eine oder mehrere Flüssigkeitsdüsen (32) enthaltende Ablösevorrichtung (10) und eine Folientransportvorrichtung (58) umfaßt, wobei die Flüssigkeitsdüsen (32) benachbart zu der durch die Fördervorrichtung gebildete Transportebene angeordnet sind, dadurch gekennzeichnet, daß die Flüssigkeitsdüsen (32) der Ablösevorrichtung Hochdruckflüssigkeitsdüsen sind.

15. Vorrichtung nach Anspruch 14, dadurch gekennzeichnet, daß die Düsen (32) Flachstrahldüsen sind.

16. Vorrichtung nach einem der Ansprüche 14 oder 15, dadurch gekennzeichnet, daß die Strahlrichtung der Düsen (32) mit der Transportebene der Trägerplatten (12) einen Winkel von zirka 10° bis 60° bildet.

17. Vorrichtung nach einem der Ansprüche 14 bis 16, dadurch gekennzeichnet, daß der Abstand der Düsenöffnungen zur Transportebene zirka 5 bis 20 mm beträgt.

18. Vorrichtung nach Anspruch 17, dadurch gekennzeichnet, daß die Trägerplattenfördervorrichtung eine Austaktvorrichtung umfaßt, die in Transportrichtung stromabwärts von der Ablösevorrichtung (10) angeordnet ist und die in Abhängigkeit von Sensorsignalen der Trägerplattenfördervorrichtung und der Folientransportvorrichtung aktivierbar ist.

19. Vorrichtung nach einem der Ansprüche 14 bis 18, dadurch gekennzeichnet, daß der Flüssigkeitsstrahl (34) in Abhängigkeit der Position der Trägerplatte (12) in Transportrichtung von Hochdruck auf Niederdruck bzw. umgekehrt schaltbar ist.

20. Vorrichtung nach einem der Ansprüche 14 bis 19, dadurch gekennzeichnet, daß die Ablösevorrichtung (10) eine Bürstenwalze (36) umfaßt, die quer zur Transportrichtung der Trägerplatten (12) und zu deren Transportebene benachbart angeordnet und gegen die Transportrichtung der Trägerplatten (12) drehbar antreibbar ist.

21. Vorrichtung nach einem der Ansprüche 14 bis 20, dadurch gekennzeichnet, daß die Folientransportvorrichtung (58) eine Abziehwalze (24) umfaßt, die in federndem Kontakt mit den Trägerplatten (12) angeordnet ist.

## Claims

1. Method for removing a covering sheet (14, 15) from a plate-like support (12), particularly for removing a protective film covering a photoresist coating on a printed circuit board, in which in a first stage one edge of the covering sheet (14, 15) is raised by a removal device (10) and in a second stage gripped by a sheet conveying device (58), which, with advancing removal from the support, takes the sheet out of the vicinity of the removal device, characterized in that the edge of the covering sheet (14, 15) is raised from the plate-like support (12) by one or more high pressure liquid jets (34).

2. Method according to claim 1, characterized in that the liquid is sprayed with a pressure of approximately 40 to 60 bar against the edge of the sheet (14, 15).

3. Method according to one of the claims 1 or 2, characterized in that the liquid is sprayed in the form of a flat jet against the sheet edge, the flat jet being oriented in such a way that the longitudinal extension of the jet cross-section is parallel to the sheet edge.

4. Method according to one of the preceding claims, characterized in that the edge of the sheet (14, 15) is raised over its entire width and approximately simultaneously by a plurality of liquid jets (34) striking the edge in spaced manner.

5. Method according to one of the preceding claims, characterized in that the high pressure liquid jet (34) only acts to raise the sheet edge on the covering sheet, but for at least sufficiently long that it is gripped with its front end by the sheet conveying device (58) and that following onto this the further removal of the sheet (14, 15) is assisted by a low pressure liquid jet (34).

6. Method according to claim 5, characterized in that the liquid jet (34) for the further removal of the sheet has a liquid pressure of up to approximately 5 bar.

7. Method according to one of the preceding claims, characterized in that the sheet (14, 15) raised by the high pressure jet (34) is supplied to the sheet conveying device (58) by a brush roll (36) rotating in opposition to the conveying direction of the support plate (12).

8. Method according to one of the preceding claims, characterized in that the conveying speed of the sheet conveying device (58) is higher than the conveying speed of the plate-like support (12) and is optionally at least the same as the circumferential speed of the brush roll (36).

9. Method according to one of the preceding claims, characterized in that the sheet (14, 15) located in the vicinity of the sheet conveying device (58) is smoothed by tension acting at transverse to the conveying direction on conveying out of the vicinity of the removal device (10).

10. Method according to one of the preceding claims, characterized in that at the end of the sheet conveying device (58), the sheet (14, 15) is taken up by a reeling device (74).

11. Method according to claim 10, characterized in that the sheet is supplied by a rotating brush roll (76) to the reeling device (74).

12. Method according to one of the preceding claims, characterized in that the removal of the sheet (14, 15) is monitored by means of a sensor (72) in the vicinity of the sheet conveying device (58).

13. Method according to claim 12, characterized in that the signal of a sensor, which identifies the position of the support in the conveying direction, is linked with the signal of the sensor (72) of the sheet conveying device (58) to form a clock-out signal, which is used for discharging the support plates (12) out of the production process, when the covering sheet (14, 15) has not been correctly removed.

14. Apparatus for removing a covering sheet from a plate-like support (12), in which the apparatus comprises a conveying device (18, 26) for the plate-like supports (12), a removal device (10) containing one or more liquid nozzles (32) and a sheet conveying device (58), the liquid nozzles (32) being positioned adjacent to the conveying plane formed by the conveying device, characterized in that the liquid nozzles (32) of the removal device are high pressure nozzles.

15. Apparatus according to claim 14, characterized in that the nozzles (32) are flat jet nozzles.

16. Apparatus according to one of the claims 14 or 15, characterized in that the jet direction of the nozzles (32) forms an angle of approximately 10° to 60° with the conveying plane of the support plates (12).

17. Apparatus according to one of the claims 14 to 16, characterized in that the spacing of the nozzle apertures with respect to the conveying plane is approximately 5 to 20 mm.

18. Apparatus according to claim 17, characterized in that the support plate conveying device comprises a clock-out device, which is located downstream of the removal device (10) in the conveying direction and which can be activated as a function of sensor signals of the support plate conveying device and the sheet conveying device.

19. Apparatus according to one of the claims 14 to 18, characterized in that the liquid jet (34) can be switched from high pressure to low pressure or vice versa, as a function of the position of the support plate (12) in the conveying direction.

20. Apparatus according to one of the claims 14 to 19, characterized in that the removal device (10) incorporates a brush roll (36), which is positioned at transverse to the conveying direction of the support plates (12) and adjacent to their conveying plane and is rotatable counter to the conveying direction of the support plates (12).

21. Apparatus according to one of the claims 14 to 20, characterized in that the sheet conveying device (58) incorporates a pull-off roll (24), which is in resilient contact with the support plates (12).

## Revendications

1. Procédé pour enlever une feuille de recouvrement (14, 15) d'un support en forme de plaque (12), en particulier pour enlever une pellicule protectrice qui recouvre une couche de laque photosensible sur une plaque pour circuit imprimé, un bord de la feuille de recouvrement (14, 15) étant soulevé dans un premier temps par un dispositif de séparation (10) et saisi dans un deuxième temps par un dispositif de transport des feuilles (58) qui éloigne la feuille de la région du dispositif de séparation lorsque la séparation de la feuille se poursuit, caractérisé par le fait que le bord de la feuille de recouvrement (14, 15) est soulevé du support en forme de plaque (12) par un ou plusieurs jets de liquide sous haute pression (34).

2. Procédé selon la revendication 1, caractérisé par le fait que le liquide est projeté sur le bord de la feuille (14, 15) sous une pression de 40 à 60 bars environ.

3. Procédé selon l'une des revendications 1 et 2, caractérisé par le fait que le liquide est projeté sur le bord de la feuille sous la forme d'un jet plat, cependant que le jet plat est orienté d'une manière telle que la direction longitudinale de la section transversale du jet s'étende parallèlement au bord de la feuille.

4. Procédé selon l'une des revendications précédentes, caractérisé par le fait que le bord de la feuille (14, 15) est soulevé à peu près en même temps sur la totalité de sa largeur par plusieurs jets de liquide (34) qui rencontrent le bord à distance les uns des autres.

5. Procédé selon l'une des revendications précédentes, caractérisé par le fait que le jet de liquide sous haute pression (34) n'agit que pour soulever le bord de la feuille de recouvrement (14, 15), mais cela au moins aussi longtemps pour que celle-ci soit saisie par son extrémité avant par le dispositif de transport des feuilles (58), et par le fait qu'à la suite de cela, la séparation ultérieure de la feuille (14, 15) est favorisée par un jet de liquide sous basse pression (34).

6. Procédé selon la revendication 5, caractérisé par le fait que le jet liquide (34) qui est destiné à la poursuite de la séparation de la feuille présente une pression allant jusqu'à 5 bars environ.

7. Procédé selon l'une des revendications précédentes, caractérisé par le fait que la feuille (14, 15) soulevée par le jet sous haute pression (34) est amenée au dispositif de transport des feuilles (58) au moyen d'une brosse rotative (36) qui tourne à l'opposé de la direction de transport de la plaque formant support (12).

8. Procédé selon l'une des revendications précédentes, caractérisé par le fait que l'on choisit pour la vitesse de transport du dispositif de transport des feuilles (58) une valeur qui est supérieure à la vitesse de transport des supports en forme de plaques (12), et qui est de préférence au moins égale à la vitesse circonférentielle de la brosse rotative (36).

9. Procédé selon l'une des revendications précédentes, caractérisé par le fait que la feuille (14, 15) qui se trouve dans la région du dispositif de transport des feuilles (58) est lissée lors de son évacuation hors de la région du dispositif de séparation (10) par des forces de traction agissant transversalement à la direction du transport.

10. Procédé selon l'une des revendications précédentes, caractérisé par le fait que la feuille (14, 15) est reprise par un dispositif d'enroulement (74) à l'extrémité du dispositif de transport des feuilles (58).

11. Procédé selon la revendication 10, caractérisé par le fait que la feuille est amenée au dispositif d'enroulement (74) par une brosse rotative tournante (76).

12. Procédé selon l'une des revendications précédentes, caractérisé par le fait que la séparation de la feuille (14, 15) est surveillée par l'intermédiaire d'un capteur (72) dans la région du dispositif de transport des feuilles (58).

13. Procédé selon la revendication 12, caractérisé par le fait que le signal d'un capteur qui détecte la position du support dans la direction du transport est combiné avec le signal du capteur (72) du dispositif de transport des feuilles (58) pour donner un signal de désynchronisation qui sert à retirer du processus de production les plaques formant supports (12) pour lesquelles la feuille de recouvrement (14, 15) n'a pas été correctement enlevée.

14. Dispositif pour enlever une feuille de recouvrement d'un support en forme de plaque (12), le dispositif comprenant un dispositif de déplacement (18, 26) destiné aux supports en forme de plaques (12), un dispositif de séparation (10) comprenant une ou plusieurs buses à liquide (32), et un dispositif de transport des feuilles (58), cependant que les buses à liquide (32) sont disposées au voisinage du plan de transport formé par le dispositif de déplacement, caractérisé par le fait que les buses à liquide (32) du dispositif de séparation sont des buses à liquide sous haute pression.

15. Dispositif selon la revendication 14, caractérisé par le fait que les buses (32) sont des buses a jet plat.

16. Dispositif selon l'une des revendications 14 et 15, caractérisé par le fait que la direction du jet des buses (32) forme un angle de 10 à 60° environ avec le plan de transport des plaques formant supports (12).

17. Dispositif selon l'une des revendications 14 à 16, caractérisé par le fait que la distance des orifices des buses par rapport au plan de transport est de 5 à 20 mm environ.

18. Dispositif selon la revendication 17, caractérisé par le fait que le dispositif de déplacement des plaques formant supports comporte un dispositif de désynchronisation qui est disposé en aval du dispositif de séparation (10) dans la direction du transport et qui peut être activé en fonction de signaux émanant de capteurs du dispositif de déplacement des plaques formant supports et du dispositif de transport des feuilles.

19. Dispositif selon l'une des revendications 14 à 18, caractérisé par le fait que le jet de liquide (34) peut passer de la haute pression à la basse pression et inversement, respectivement, en fonction de la position de la plaque formant support (12) dans la direction du transport.

20. Dispositif selon l'une des revendications 14 à 19, caractérisé par le fait que le dispositif de séparation (10) comprend une brosse rotative (36) qui est disposée transversalement par rapport à la direction du transport des plaques formant supports (12), au voisinage du plan de transport de celles-ci, et qui peut être entraînée en rotation à l'opposé de la direction du transport des plaques formant supports (12).

21. Dispositif selon l'une des revendications 14 à 20, caractérisé par le fait que le dispositif de transport des feuilles (58) comprend un rouleau d'enlèvement (24) qui est disposé en contact élastique avec les plaques formant supports (12).
